# EUROPÄISCHE PATENTSCHRIFT

(11) **EP 1 748 347 B1**
(45) Veröffentlichungstag und Bekanntmachung des Hinweises auf die Patenterteilung: **06.11.2013**
(21) Anmeldenummer: 06013849.2
(22) Anmeldetag: 04.07.2006
(51) Int. Cl.: H05K 7/14, G06F 1/18, H05K 1/14

(54) **Computereinschubmodul**
computer slot module
module informatique insérable

(30) Priorität: 25.07.2005 DE 102005034664
(43) Veröffentlichungstag der Anmeldung: 31.01.2007
(73) Patentinhaber: Fujitsu Technology Solutions Intellectual Property GmbH, 80807 München (DE)
(72) Erfinder: Salmen, Reinhard, 33165 Lichtenau (DE); Schräder, Bernhard, 33129 Delbrück (DE)
(74) Vertreter: Epping - Hermann - Fischer

(56) Entgegenhaltungen:
- EP-A- 0 889 684
- WO-A-98/01801
- US-A1- 2002 093 795
- US-B1- 6 362 974
- US-B1- 6 496 384

## Beschreibung

Die Erfindung betrifft eine Computeranordnung, aufweisend einen Gehäuseschrank zum Einschub wenigstens zweier Computereinschubmodule, ein erstes Computereinschubmodul mit einer ersten Systemplatine, wenigstens einem ersten Prozessor und einem ersten Datenbus und ein zweites Computereinschubmodul mit einer zweiten Systemplatine, wenigstens einem zweiten Prozessor oder Erweiterungsmodul und einem zweiten Datenbus. Die Erfindung betrifft des Weiteren ein Computereinschubmodul, das zum Einsatz in einer solchen Computeranordnung geeignet ist.

Computeranordnungen bestehend aus einem Gehäuseschrank und mehreren Computereinschubmodulen sind vielfach bekannt. Solche Computeranordnungen werden insbesondere in Rechenzentren verwendet, um möglichst viel Rechenleistung auf einer möglichst kleinen Fläche unterzubringen. Insbesondere so genannte Webhoster stellen eine Großzahl von Computereinschubmodulen zum Bereitstellen von Speicherplatz und Serverkapazität zur Verfügung.

Durch die Verwendung von Computerschränken mit Einschubmodulen kann eine zentrale Infrastruktur, beispielsweise bestehend aus einer Stromversorgung, Netzwerkverbindungen, Kühlanlagen und Steuervorrichtungen, bereitgestellt werden. Dadurch und durch die Verwendung von Standardkomponenten können die einzelnen Einschubmodule besonders preisgünstig gefertigt und angeboten werden. Dabei haben sich insbesondere Einschubmodule mit zwei Prozessoren am Markt durchgesetzt.

Die Beschränkung auf vorgegebene Standardkomponenten, insbesondere auch vorgegebene, relativ kleine Gehäusetypen birgt jedoch auch Nachteile. So ist eine Erweiterung bestehender Einschubmodule kaum möglich.

In Anwendungsfeldern, in denen besonders viel Rechenleistung benötigt wird, werden deshalb Einschubmodule eingesetzt, die mehr als einen Einschubplatz in einem Gehäuseschrank belegen. Beispielsweise setzen so genannte Applikationshoster, die neben Speicherplatz auch vermehrt Rechenleistung anbieten, Computereinschubmodule mit mehr als zwei Prozessoren oder größerem Arbeitsspeicher ein.

Dabei ist es jedoch von Nachteil, dass bereits genutzte Einschubmodule nicht oder nur eingeschränkt weiter genutzt werden können. Umgekehrt ist es auch schwierig, ein solches großes Einschubmodul zu teilen, beispielsweise um es für zwei verschiedene Kunden oder Einsatzzwecke zu benutzen.

Aus der US2002/0093795A1 ist ein Computereinschubmodul bekannt.

Aus der WO 98/01801 A1 ist ein Gehäuse für ein elektronisches Gerät bekannt, in welches eine Leiterplatte einsetzbar ist. Auf die Leiterplatte ist eine weitere Leiterplatte einsteckbar. Die weitere Leiterplatte vermag durch einen Durchbruch in einer Gehäusewand hindurchzuragen. An die mit dem Durchbruch versehene Gehäusewand ist ein Zusatzgehäuse zur Aufnahme von Zusatz-Leiterplatten ansetzbar.

Aus der US 6,496,384 B1 ist eine Leiterplattenanordnung bekannt. Die Anordnung umfasst eine erste Leiterplatte, die eine Öffnung aufweist, und eine zweite Leiterplatte mit einer Kante. Zur elektrischen Kontaktierung wird die Kante der zweiten Leiterplatte in die Öffnung der ersten Leiterplatte eingeführt. Eine Lötverbindung dient zum Verbinden der ersten Leiterplatte und der zweiten Leiterplatte.

Aufgabe der Erfindung ist es, ein Computereinschubmodule zur Verwendung in Computeranordnungen zu beschreiben, das besonders flexibel eingesetzt werden kann.

Die Aufgabe wird erfindungsgemäß durch ein Computereinschubmodul mit den Merkmalen des Anspruchs 1 sowie durch eine Verwendung des Einschubmoduls in einer Computeranordnung nach Anspruch 7 gelöst.

Erfindungsgemäß können zwei solche Computereinschubmodule durch eine gemeinsame Leiterplatte so miteinander verbunden werden, dass das erste und das zweite Computereinschubmodul ein gemeinsames Computersystem bilden. Dadurch wird es ermöglicht, zwei einfache Computereinschubmodule, die aus Standardkomponenten aufgebaut sind und jeweils einen einzelnen Einschubplatz in einem Gehäuseschrank einnehmen, zu einem leistungsfähigeren Computersystem zu verbinden, das zwei übereinander liegende Einschubplätze in einem Computerschrank einnimmt. Umgekehrt kann ein solches, großes Computermodul wieder in seine einzelnen Computereinschubmodule zerlegt werden, sodass diese auch separat einsetzbar sind.

Die Verbindung mittels einer Leiterplatte hat den Vorteil, dass mechanische Toleranzen im Abstand der ersten und der zweiten Systemplatine des ersten und des zweiten Computereinschubmoduls toleriert werden können. Des Weiteren erlaubt eine Kopplung mittels Leiterplatte eine Datenübertragung mit sehr hohen Datenraten bei einem verhältnismäßig niedrigen Preis.

Alternative Lösungen zum Verbinden zweier Leiterplatten, die beispielsweise flexible Kabel für eine Datenübertragungen mit Signalbandbreite von mehr als 2 GBit/s verwenden, sind wesentlich teurer. Des Weiteren haben solche Lösungen den Nachteil, dass die Montage der Kabel, etwa an der Rückseite der Einschubmodule, sehr schwierig ist, wenn kein freier Zugang zu der Geräterückseite besteht. Zudem sind solche Kabel mechanisch nur sehr gering belastbar, was insbesondere beim Einbau von Erweiterungseinheiten störend ist.

Um die verbindende Leiterplatte einfach durch die Systemplatinen und die darauf angeordneten Anschlüsse der Computereinschubmodule durchzustecken, ist in den Systemplatinen der Einschubmodule eine Aussparung im Bereich der Anschlüsse vorgesehen. Die Leiterplatte kann dabei auf einer verhältnismäßig langen Länge die Anschlüsse der Systemplatinen kontaktieren, sodass der Abstand der Systemplatinen zueinander sich in einem verhältnismäßig großem Toleranzbereich bewegen kann.

Weitere Einzelheiten und Ausgestaltungen der Erfindung sind in den Unteransprüchen angegeben.

Die Erfindung wird nachfolgend an zwei Ausführungsbeispielen anhand der Zeichnungen näher erläutert. In den Zeichnungen zeigen:
Figur 1 eine Computersystem bestehend aus zwei Computereinschubmodulen, die über eine Leiterplatte miteinander verbunden sind,
Figur 2 eine Computeranordnung aufweisend einen Gehäuseschrank und zwei Computereinschubmodule, die über eine Leiterplatte miteinander verbindbar sind.

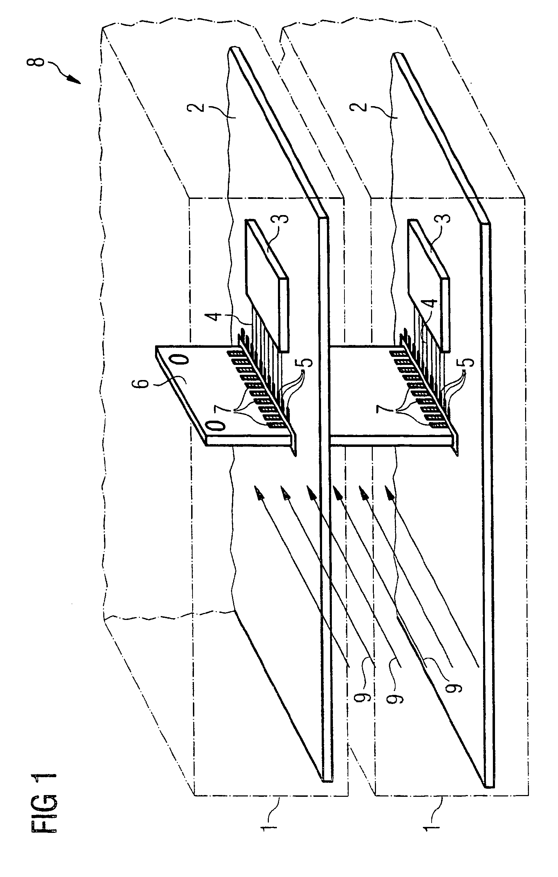

Figur 1 zeigt zwei Computereinschubmodule 1. Die Computereinschubmodul 1 weisen jeweils eine Systemplatine 2 mit einem Prozessor 3 auf. Die Prozessoren 3 sind jeweils über Datenleitungen 4 mit Kontaktpads 5, die in der Ausgestaltung als Anschluss dienen, verbunden.

Die beiden Computereinschubmodule 1 sind über eine Leiterplatte 6 miteinander verbunden. Die Leiterplatte 6 weist Leiterbahnen 7 auf, die mit den Kontaktpads 5 der Systemplatinen 2 zusammenwirken. Durch die Kopplung mittels der Leiterplatte 6 bilden die zwei Computereinschubmodule 1 ein gemeinsames Computersystem 8 mit den beiden Prozessoren 3, die über den gemeinsamen Bus bestehend aus Datenleitungen 4 und Leiterbahnen 7 verbunden sind.

Die Leiterbahnen 7 der Leiterplatte 6 können die Kontaktpads 5 der Systemplatinen 2 auf einem verhältnismäßig großen Bereich kontaktieren. Daher ist der Abstand der Computereinschubmodule 1 zueinander in einem Toleranzbereich anpassbar. Insbesondere können die Computereinschubmodule 1 so beabstandet werden, dass ein kühlender Luftstrom, der in der Figur 1 durch die Pfeile 9 angedeutet ist, zwischen den Computereinschubmodulen 1 möglich ist.

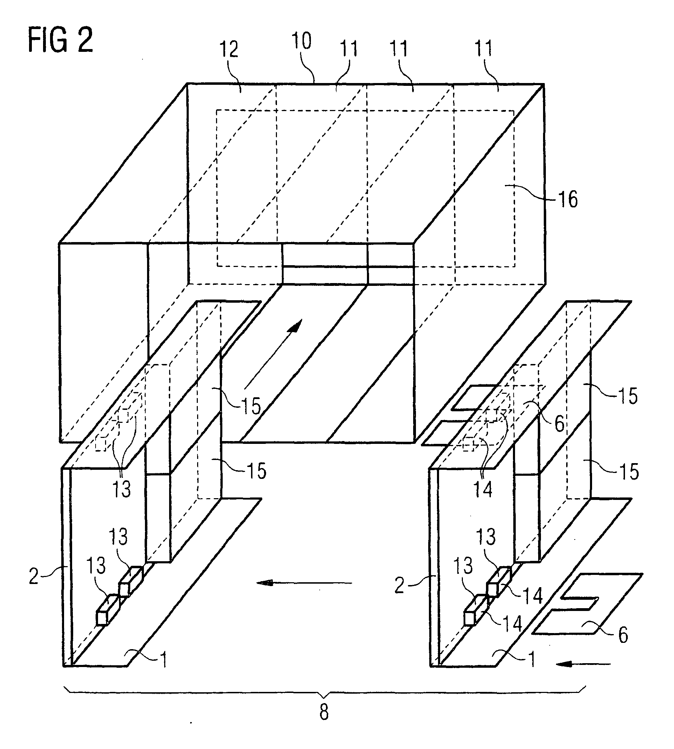

Figur 2 zeigt eine zweite Ausgestaltung der Erfindung. Ein Gehäuseschrank 10 umfasst drei Einschubsteckplätze 11 und ein gemeinsames Netzteil 12. Des Weiteren weist der Gehäuseschrank 10 eine Rückwand 16 auf, über die die Einschubplätze mit Strom von dem Netzteil 12 versorgt werden können. Es ist ebenfalls möglich, weitere Versorgungs- und Steuervorrichtungen in die Rückwand 16 zu integrieren, beispielsweise die Zu- oder Abfuhr von Kühlluft oder Anschlussmöglichkeiten an ein Datennetz.

In dem Ausführungsbeispiel sind zwei Computereinschubmodule 1 gezeigt, die in dem Gehäuseschrank 10 eingeschoben werden sollen. Die Computereinschubmodule 1 weisen jeweils eine Systemplatine 2 auf. Auf den Systemplatinen 2 sind als Anschlüsse Steckverbinder 13 angeordnet, wobei die Systemplatinen 2 Aussparungen 14 im Bereich der Steckverbinder 13 aufweisen. Auch das Chassis des Computereinschubmoduls 1 weist Aussparungen im Bereich der Steckverbinder 13 auf.

Die beiden Computereinschubmodule 1 können über zwei Leiterplatten 6 im Bereich der linken und rechten Gehäusewandung des Computereinschubmoduls 1 miteinander verbunden werden. Die Anordnung der Leiterplatten 6 im Bereich der Gehäusewand der Computereinschubmodule 1 ermöglicht dabei nicht nur eine elektrische sondern auch eine mechanisch stabile Kopplung der Computereinschubmodule 1.

Es ist möglich, dass beide Systemplatinen 2 jeweils einen oder mehrere Prozessoren 3 (in Figur 2 nicht dargestellt) aufweisen, die erfindungsgemäß gekoppelt werden. Selbstverständlich kann auch eine Kopplung von Computereinschubmodulen 1 vorgenommen werden, die an Stelle eines Prozessors 3 andere Erweiterungsmodule 15 aufweisen.

Durch die Kopplung der Computereinschubmodule 1 können die Erweiterungsmodule 15, beispielsweise eingebaute Festplatten oder sonstige Computerkomponenten, wie in einem einzelnen Computersystem genutzt werden. Auf diese Weise ist es möglich, ein Computersystem 8 mit einer gegenüber den einzelnen Computereinschubmodulen 1 verdoppelten Rechenleistung, Speicherkapazität bzw. Ein-/Ausgabeleistung bereitzustellen.

### Bezugszeichenliste

- 1: Computereinschubmodul
- 2: Systemplatine
- 3: Prozessor
- 4: Datenleitung
- 5: Kontaktpad
- 6: Leiterplatte
- 7: Leiterbahn
- 8: Computersystem
- 9: Luftstrom
- 10: Gehäuseschrank
- 11: Einschubplatz
- 12: Netzteil
- 13: Steckverbinder
- 14: Aussparung
- 15: Erweiterungsmodul
- 16: Rückwand

## Patentansprüche

1. Computereinschubmodul (1) zur Anordnung in einem Einschubsteckplatz (11) einer Mehrzahl von Einschubsteckplätzen (11) eines Gehäuseschranks (10), wobei der Gehäuseschrank (10) eine Rückwand (16) zur Versorgung der Mehrzahl von Einschubsteckplätzen (11) mit Strom aufweist, aufweisend
- ein Chassis,
- eine erste Systemplatine (2),
- wenigstens einen Prozessor (3) und
- einen Datenbus, wobei
die erste Systemplatine (2) als Anschluss dienende Kontaktpads (5) umfasst, der Anschluss dazu eingerichtet ist, den Datenbus eines weiteren Computereinschubmoduls (1) derselben Art über eine Leiterplatte (6) zu verbinden und im Bereich des Anschlusses jeweils eine Aussparung (14) der ersten Systemplatine (2) vorgesehen ist, so dass die Leiterplatte (6) zum Verbinden des Computereinschubmoduls (1) durch die erste Systemplatine (2) durchsteckbar ist und Leiterbahnen (7) der Leiterplatte (6) mit den Kontaktpads (5) der ersten Systemplatine (2) zusammenwirken.

2. Computereinschubmodul (1) nach Anspruch 1,
**dadurch gekennzeichnet, dass**
der Anschluss als Steckverbinder (13) ausgeführt ist.

3. Computereinschubmodul (1) nach Anspruch 2,
der Steckverbinder (13) gewinkelt gegenüber der ersten Systemplatine (2) angeordnet ist, sodass die Leiterplatte (6) zum Verbinden des Computereinschubmoduls (1) senkrecht zur ersten Systemplatine (2) in den Steckverbinder (13) einsteckbar ist.

4. Computereinschubmodul (1) nach einem der Ansprüche 1 bis 3, **dadurch gekennzeichnet, dass**
der Anschluss im Inneren der ersten Systemplatine (2) angeordnet ist.

5. Computereinschubmodul (1) nach einem der Ansprüche 1 bis 3, **dadurch gekennzeichnet, dass**
der Anschluss am Rand der ersten Systemplatine (2) angeordnet ist.

6. Computereinschubmodul (1) nach einem der Ansprüche 1 bis 5, **dadurch gekennzeichnet, dass**
der Datenbus eine Vielzahl von Datenleitungen (4) aufweist.

7. Verwendung eines Computereinschubmoduls (1) mit einer ersten Systemplatine (2) nach einem der Ansprüche 1 bis 6 als erstes Computereinschubmodul (1) in einer Computeranordnung, aufweisend
- einen Gehäuseschrank (10) zum Einschub wenigstens zweier Computereinschubmodule (1),
- das erstes Computereinschubmodul (1) mit der ersten Systemplatine (2) und
- ein zweites Computereinschubmodul (1) mit einer zweiten Systemplatine (2), wenigstens einem zweiten Prozessor (3) oder einem Erweiterungsmodul (15), einem zweiten Datenbus, und einem Kontaktpads (5) umfassenden Anschluss, wobei
- das erste und das zweite Computereinschubmodul (1) übereinander in dem Gehäuseschrank (10) angeordnet sind,
- die Kontaktpads (5) der Anschlüsse des ersten und des zweiten Computereinschubmoduls (1) Leiterbahnen (7) einer die Leiterbahnen (7) aufweisenden Leiterplatte (6) kontaktieren, so dass das erste und das zweite Computereinschubmodul (1) als ein gemeinsames Computersystem (8), aufweisend den wenigstens ersten Prozessor und den zweiten Prozessor (3) oder das Erweiterungsmodul (15) und einen gemeinsamen Datenbus, betreibbar sind.

8. Verwendung des Computereinschubmoduls (1) nach Anspruch 7, **dadurch gekennzeichnet, dass**
der Gehäuseschrank (10) der Computeranordnung zusätzlich eine Rückwand (16) aufweist, wobei das erste und das zweite Computereinschubmodul (1) mit der Rückwand (16) verbunden sind, um die Computereinschubmodule (1) mit Strom zu versorgen.

9. Verwendung des Computereinschubmoduls (1) nach Anspruch 8, **dadurch gekennzeichnet, dass**
über die Rückwand (16) zusätzlich eine Netzwerkverbindung für das erste und zweite Computereinschubmodul (1) herstellbar ist.

## Claims

1. Computer plug-in module (1) for arrangement in one insertion slot (11) from a plurality of insertion slots (11) in a housing cabinet (10), wherein the housing cabinet (10) has a backplane (16) for supplying power to the plurality of insertion slots (11), having
- a chassis,
- a first system board (2),
- at least one processor (3) and
- a data bus, wherein
the first system board (2) comprises contact pads (5) serving as a connection, the connection is set up to connect the data bus of a further computer plug-in module (1) of the same type via a printed circuit board (6), and a respective cutout (14) in the first system board (2) is provided in the region of the connection, as a result of which the printed circuit board (6) can be pushed through the first system board (2) in order to connect the computer plug-in module (1), and conductor tracks (7) on the printed circuit board (6) interact with the contact pads (5) on the first system board (2).

2. Computer plug-in module (1) according to Claim 1,
**characterized in that**
the connection is embodied as a plug connector (13).

3. Computer plug-in module (1) according to Claim 2,
**characterized in that**
the plug connector (13) is arranged at an angle relative to the first system board (2), as a result of which the printed circuit board (6) can be inserted into the plug connector (13) perpendicular to the first system board (2) in order to connect the computer plug-in module (1).

4. Computer plug-in module (1) according to one of Claims 1 to 3, **characterized in that**
the connection is arranged inside the first system board (2).

5. Computer plug-in module (1) according to one of Claims 1 to 3, **characterized in that**
the connection is arranged at the edge of the first system board (2).

6. Computer plug-in module (1) according to one of Claims 1 to 5, **characterized in that**
the data bus has a multiplicity of data lines (4).

7. Use of a computer plug-in module (1) having a first system board (2) according to one of Claims 1 to 6 as a first computer plug-in module (1) in a computer arrangement, having
- a housing cabinet (10) for plugging in at least two computer plug-in modules (1),
- the first computer plug-in module (1) having the first system board (2), and
- a second computer plug-in module (1) having a second system board (2), at least one second processor (3) or an expansion module (15), a second data bus, and a connection comprising contact pads (5), wherein
- the first and second computer plug-in modules (1) are arranged above one another in the housing cabinet (10),
- the contact pads (5) of the connections on the first and second computer plug-in modules (1) make contact with conductor tracks (7) on a printed circuit board (6) having the conductor tracks (7), as a result of which the first and second computer plug-in modules (1) can be operated as a conjoint computer system (8), having the at least first processor and the second processor (3) or the expansion module (15) and a shared data bus.

8. Use of the computer plug-in module (1) according to Claim 7, **characterized in that**
the housing cabinet (10) of the computer arrangement additionally has a backplane (16), wherein the first and second computer plug-in modules (1) are connected to the backplane (16) in order to supply power to the computer plug-in modules (1).

9. Use of the computer plug-in module (1) according to Claim 8, **characterized in that**
the backplane (16) can additionally be used to set up a network connection for the first and second computer plug-in modules (1).

## Revendications

1. Module informatique enfichable (1) destiné à être monté dans un emplacement d'insertion (11) d'une pluralité d'emplacements d'insertion (11) d'une baie de bâtis (10), dans lequel la baie de bâtis (10) présente une paroi arrière (16) destinée à alimenter en courant la pluralité de logements d'insertion (11), comprenant
- un châssis,
- une première carte système (2),
- au moins un processeur (3) et
- un bus de données, dans lequel
la première carte système (2) comprend des plots de contact (5) jouant le rôle de borne de connexion, la borne de connexion est apte à relier le bus de données d'un autre module informatique enfichable (1) de même type par l'intermédiaire d'une carte de circuit imprimé (6) et un évidement (14) respectif est prévu dans la région de la borne de connexion de la première carte système (2), de sorte que la carte de circuit imprimé (6) peut être insérée à travers la première carte système (2) pour connecter le module informatique enfichable (1) et des pistes conductrices (7) de la carte de circuit imprimé (6) coopèrent avec les plots de contact (5) de la première carte système (2).

2. Module informatique enfichable (1) selon la revendication 1, **caractérisé en ce que** la borne de connexion est réalisée sous la forme d'un connecteur (13).

3. Module informatique enfichable (1) selon la revendication 2, **caractérisé en ce que** le connecteur (13) est agencé de manière inclinée par rapport à la première carte système (2) de telle sorte que la carte de circuit imprimé (6) puisse être insérée dans le connecteur (13) pour connecter le module informatique enfichable (1) perpendiculairement à la première carte système (2).

4. Module informatique enfichable (1) selon l'une quelconque des revendications 1 à 3, **caractérisé en ce que** la borne de connexion est disposée à l'intérieur de la première carte système (2).

5. Module informatique enfichable (1) selon l'une quelconque des revendications 1 à 3, **caractérisé en ce que** la borne de connexion est disposée sur le bord de la première carte système (2).

6. Module informatique enfichable (1) selon l'une quelconque des revendications 1 à 5, **caractérisé en ce que** le bus de données comprend une pluralité de lignes de données (4).

7. Utilisation d'un module informatique enfichable (1) comprenant une première carte système (2) selon l'une quelconque des revendications 1 à 6 en tant que premier module informatique enfichable (1) dans un système d'ordinateur, comprenant
- une baie de bâtis (10) pour l'insertion d'au moins deux modules informatiques enfichables (1),
- le premier module informatique enfichable (1) comportant la première carte système (2) et
- un second module informatique enfichable (1) comportant une seconde carte système (2), au moins un second processeur (3) ou un module d'extension (15), un second bus de données, et une borne de connexion comprenant des plots de contact (5), dans lequel
- les premier et second modules informatiques enfichables (1) sont disposés l'un au-dessus de l'autre dans la baie de bâtis (10),
- les plots de contact (5) des bornes de connexion des premier et second modules informatiques enfichables (1) viennent au contact de pistes conductrices (7) d'une carte de circuit imprimé (6) comportant les pistes conductrices (7), de telle sorte que les premier et second modules informatiques enfichables (1) puissent être mis en fonctionnement en tant que système informatique commun (8) comprenant l'au moins un premier processeur et le second processeur (3) ou le module d'extension (15) et un bus de données commun.

8. Utilisation du module informatique enfichable (1) selon la revendication 7, **caractérisé en ce que** la baie de bâtis (10) du système d'ordinateur comporte également une paroi arrière (16), dans lequel les premier et second modules informatiques enfichables (1) sont reliés à la paroi arrière (16) pour alimenter en courant les modules informatiques enfichables (1).

9. Utilisation du module informatique enfichable (1) selon la revendication 8, **caractérisé en ce qu'**une connexion réseau peut en outre être établie par l'intermédiaire de la paroi arrière (16) pour les premier et second modules informatiques enfichables (1).
